# EUROPÄISCHE PATENTANMELDUNG

(11) **EP 1 316 807 A2**
(43) Veröffentlichungstag der Anmeldung: **04.06.2003**
(21) Anmeldenummer: 02023188.2
(22) Anmeldetag: 16.10.2002
(51) Int. Cl.: G01R 31/02, G01R 31/04

(54) **Verfahren und Vorrichtung zur Lokalisierung von Unterbrechungen in einem Strompfad**

(30) Priorität: 29.11.2001 DE 10158574
(71) Anmelder: ROBERT BOSCH GMBH, 70442 Stuttgart (DE)
(72) Erfinder: Schenk, Joachim, 38536 Meinersen-Ohof (DE); Geil, Andreas, 70197 Stuttgart (DE); Spichale, Thomas, 69436 Schoenbrunn (DE); Baierl, Wolfgang, 73630 Remshalden (DE)

(57) **Zusammenfassung**

Es werden ein Verfahren und zugehörige Vorrichtungen zur Lokalisierung von Unterbrechungen angegeben, bei denen logische Abfragen und Plausibilitätsuntersuchungen in einer Recheneinrichtung ablaufen, die sowohl abgespeicherte Informationen über Systemfunktionen als auch Ausfallwahrscheinlichkeiten berücksichtigen und so möglicherweise auftretende Unterbrechungen exakt lokalisieren. Die Vorrichtungen können auch Bestandteil eines Diagnosetesters sein.

## Beschreibung

### Stand der Technik

Die Erfindung betrifft Verfahren sowie zugehörige Vorrichtungen zur Eingrenzung oder Lokalisierung von Unterbrechungen, insbesonders in einem Strompfad einer Verbindungsleitung zwischen Verbrauchern und einer Spannungsversorgungseinheit in einem Fahrzeugbordnetz, mit den Merkmalen des Anspruchs 1.

Es ist üblich, die elektrische Versorgung von sicherheitsrelevanten Verbrauchern auf ihre Funktionsfähigkeit hin zu untersuchen. Insbesondere in Kraftfahrzeugbordnetzen werden Unterbrechungen im Strompfad zwischen der Spannungsversorgungseinheit und den Verbrauchern beispielsweise durch intelligente Leistungshalbleiter oder diskrete Schaltungen, diagnostiziert.

Eine Schaltung zur Erkennung einer Leitungsunterbrechung ist beispielsweise aus der DE-OS 198 28 058 bekannt. Bei der bekannten Einrichtung, bei der ein digitales Nutzsignal mit unterschiedlichen Signalpegeln über eine Leitung geführt wird, wird eine solche Schaltung zur Erkennung einer Leitungsunterbrechung eingesetzt. Die Leitungsunterbrechung soll sowohl für einen Low-Pegel als auch für einen High-Pegel erkannt werden. Dazu werden zwei Transistoren eingesetzt, denen das zu übertragende Signal als Eingangssignal zuführbar ist und die derart an eine Versorgungsspannung angeschlossen sind, dass bei Anliegen des Low-Pegels oder des High-Pegels als Eingangssignal beide Transistoren Ausgangssignale auf gleichem Pegel erzeugen und bei Anliegen eines zwischen Low und High liegenden Signales als Eingangssignal Ausgangssignale auf vom gleichen Pegel abweichenden Pegeln erzeugt werden. Durch eine Pegelüberwachung kann dann eine Unterbrechung der Leitung erkannt werden. Eine Anwendung der bekannten Einrichtung ist die Überwachung der Verbindungsleitung zwischen einem Sensor und einem Steuergerät in einem Kraftfahrzeug.

Aus der DE-OS 197 42 092 ist ein elektrisches Kabel bekannt, über das verschiedene Verbraucher aus einer Spannungsversorgungseinrichtung, die beispielsweise in einem Steuergerät integriert ist, versorgt werden. Das Kabel weist unterschiedliche Querschnitte auf, wobei der Querschnitt an der Spannungsversorgungseinrichtung am größten ist und ist über einen Sammelstecker mit der Spannungsversorgungseinrichtung verbunden. An den Abzweigpunkten zwischen dem Kabel und den einzelnen Verbrauchern sind Leistungshalbleiter eingebaut, die einen Kurzschlußschutz gewährleisten. Eine Diagnose des Kabelbaumes ist zwar möglich, Maßnahmen zur Lokalisierung von Unterbrechungen sind bei dem bekannten Kabel jedoch nicht vorgesehen.

### Vorteile der Erfindung

Mit dem erfindungsgemäßen Verfahren mit der Merkmalskombination des Anspruchs 1 kann in vorteilhafter Weise eine Unterbrechung einer Versorgungsleitung nicht nur angezeigt werden, sondern es ist auch möglich, den genauen Ort der Unterbrechung einzugrenzen oder sogar genau zu lokalisieren. Es muß daher beim Auftreten beliebiger Unterbrechungen nicht der gesamte Strompfad untersucht werden, während bei herkömmlichen Verfahren bzw. Systemen eine Lokalisierung der Unterbrechnung nur dann möglich ist, wenn die Last, beispielsweise eine Lampe, selbst defekt ist.

Erzielt werden diese Vorteile mittels eines Verfahrens mit der Merkmalskombination des Anspruchs 1. Dabei erfolgt die Kombination mehrerer Informationen derart, dass die Eingrenzung der Unterbrechung möglich ist. Durch die Kenntnis der Steckerkonstruktion bzw. Fehlermöglichkeiten des Steckers sowie der Steckerbelegung mit Signal- und Versorgungsleitungen ist beim diagnostizieren durch Kombination der Fehler und der Konstruktionsinformationen eine Eingrenzung beziehungsweise Lokalisierung des Fehlers möglich.

Weitere Vorteile der Erfindung ergeben sich für die Merkmale der Unteransprüche.

Die erfindungsgemäße Verfahren zum Lokalisieren von Unterbrechungen wird in besonders vorteilhafter Weise in einem Kraftfahrzeug eingesetzt und dort insbesonderes zur Fehlererkennung in Versorgungsleitungen zwischen der Spannungsversorgungseinrichtung, die beispielsweise Bestandteil des Steuergerätes des Fahrzeugs ist und den einzelnen Verbrauchern beziehungsweise Lasten. Das eingesetzte Kabel wird in vorteilhafter Weise so ausgestaltet, dass sein Querschnitt bzw. die Zahl der Adern vom Steuergerät zu den Verbrauchern hin abnimmt, wobei jeweils an den Anschlüssen der einzelnen Lasten mit geringerer Aderzahl weitergefahren wird. Die Polzahl der Steckverbinder wird dazu so gewählt, dass mit steigender Entfernung vom Steuergerät geringere Polzahlen der Steckerverbinder vorhanden sind.

Die Auswertung der verschiedenen Informationen und die Plausibilitätsuntersuchung läuft in einem Prozessor, beipielsweise im Rechner des Steuergerätes selbst ab. Zur Anzeige eines Fehlers bzw. zur Anzeige des Ortes der Unterbrechung dienen Anzeigemittel, beispielsweise eine Lampe oder ein Display und/oder ein Fehlerspeicher im Steuergerät, insbesonders zur Auslesung mittels eines Diagnosetesters.

### Zeichnung

Ein Ausführungsbeispiel der Erfindung wird in der Zeichnung dargestellt und in der nachfolgenden Beschreibung näher erläutert. Dabei zeigt die beiden Figure den prinzipiellen Aufbau zweier Gesamtsysteme.

### Beschreibung

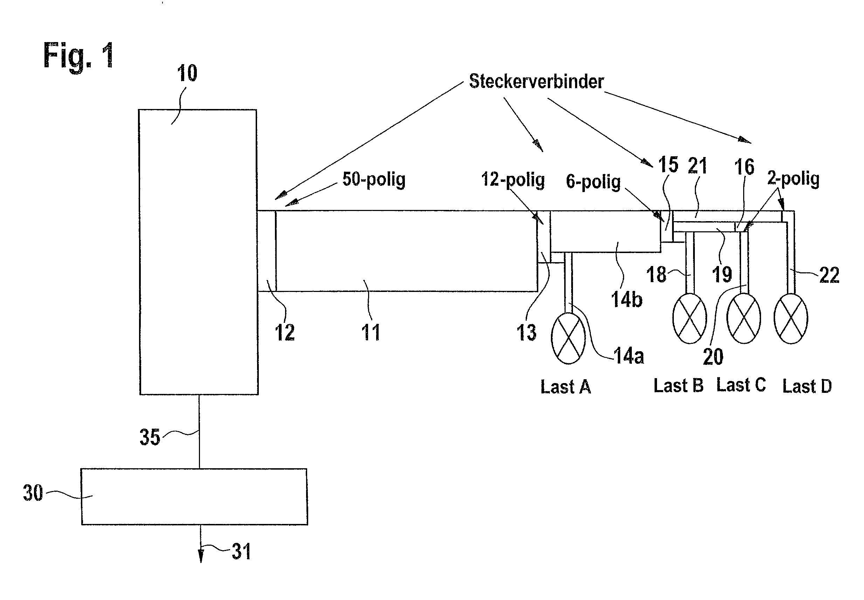

In der Figur 1 ist ein Versorgungssystem für Verbraucher dargestellt, in dem die erfindungsgemäßen Verfahren zum Lokalisieren von Unterbrechungen durchführbar sind. Die gezeigte Vorrichtung ermöglicht die Durchführung der Eingrenzung oder Lokalisierung von Unterbrechungen.

Von der Spannungsversorgungseinrichtung, die beim Ausführungsbeispiel ein Steuergerät 10 ist, führt ein mehradriges Versorgungskabel 11 bzw. ein Kabelbaum, dessen erstes Ende über einen Steckverbinder bzw. Stecker 12 beispielsweise einem 50-poligen Stecker an das Steuergerät 10 angeschlossen ist, zu dem ersten Verbraucher, der als Last A bezeichnet ist. Der Anschluß des Verbrauchers bzw. der Last A erfolgt über einen Stecker 13. Der Stecker 13 ist 12-polig. Das Kabel, das vom Stecker 13 zur Last A führt ist mit 14a bezeichnet und beispielsweise 2-adrig. Weiterhin ist an den Stecker 13 das mehradrige Kabel 14b, das vom Kabel 14a isoliert ist, angeschlossen. Die Aderzahl des Kabels 14 ist geringer als die Aderzahl des Kabels 11. Die Zahl der Adern der Kabel oder der Querschnitt der Kabel sowie die Zahl der Steckerpole sind einander bzw. den Erfordernissen angepaßt.

Über einen weiteren Stecker 15, der beispielsweise 6-polig ist, sind die weiteren Verbraucher, die als Lasten B, C und D bezeichnet sind, mit dem anderen Ende des Kabels 14 verbindbar. Die Last B steht dabei über den Stecker 15 direkt mit dem Kabel 14 in Verbindung. Die Lasten C und D sind dagegen über weitere Stecker 16 und 17 sowie zugehörige Kabel 18 bis 22 mit dem Stecker 15 verbindbar. Die Kabel 18, 19 und 21 sind beispielsweise jeweils zweiadrig und gegeneinander isoliert.

Im Steuergerät 10 läuft eine Fehlererkennung ab, die erkennen läßt, wo Unterbrechungen im Strompfad auftreten. Unter Strompfad wird dabei der gesamte Bereich zwischen dem Steuergerät 10 und dem letzten Verbraucher verstanden. Die Lokalisierung oder zumindest Eingrenzung der Lage eines möglicherweise auftretenden Fehlers bzw. einer Unterbrechung sowie die Anzeige einer erkannten Unterbrechung sind die erfindungswesentlichen Gesichtspunkte.

Zur Fehlererkennung umfaßt das Steuergerät 10 Mittel, die beispielsweise an einem oder mehreren Ausgängen A des Steuergerätes "Open Load" erkennen können. Diese Mittel werten beispielsweise auftretende Spannungen am betreffenden Ausgang A aus. Weiterhin umfaßt das Steuergerät 10 Speichermittel, in denen Informationen über die Konstruktion bzw. Fehlermöglichkeiten der Stecker 12, 13, 14, 15 und 16 abgelegt sind. Ebenfalls sind in diesen Speichermitteln Informationen über die Steckerbelegung mit Signal- und Versorgungsleitungen gespeichert. Auf diese Informationen kann der Prozessor des Steuergerätes zugreifen und erhält daraus beim Diagnostizieren durch Kombination der Fehlermöglichkeiten und der Konstruktionsinformationen die Möglichkeit eine Eingrenzug bzw. Lokalisierung der Unterbrechung vorzunehmen. Bei erkannter Lokalisierung wird diese angezeigt, wobei geeignete Anzeigemittel vorhanden sind, die im Fehlerfall vom Prozessor angesteuert werden.

Im einzelnen können zur Erkennung und Lokalisierung einer Unterbrechung im Strompfad die folgenden Verfahren ablaufen:

Wird beispielsweise an einem oder mehreren Ausgängen A des Steuergerätes "Open Load" erkannt, ist die Wahrscheinlichkeit, dass der Fehler eine offene Steckverbindung (z.B. 6-polig) ist, am größten, wenn alle Funktionen, die über diese Steckverbindung geführt werden, ausgefallen sind, bzw. Wackelkontaktverhalten aufweisen.

Bei Ausfall weiterer Funktionen kann diese Steckverbindung eher ausgeschlossen werden und ein eventuell vorhandener vorheriger vielpoliger Stecker 12 oder 13 mit 50 beziehungsweise 12 Polen als Fehlerquelle diagnostiziert werden. Bei Ausfall von Teilfunktionen, die über diese Steckverbindung führen, ist die Wahrscheinlichkeit am größten, an einer nachfolgenden Steckverbindung (2-polig) oder einer defekten Last B, C, D auf eine Fehlfunktion bzw. eine Unterbrechung zu stoßen.

Durch die Information über die Lage der Kontakte am Steckverbinder kann sogar ein halb/schräggesteckter Stecker diagnostiziert beziehungsweise als Fehler ausgeschlossen werden, wenn z.B. nur die Signale von diagonal angeordneten Kontakten Fehler aufweisen.

Mit einer Klassifizierung der Wahrscheinlichkeiten von:
Kombination von Fehlerinformation entsprechend einer Funktionskombination einer Steckverbindung,
Ausfallverhalten: Wackelkontaktverhalten erst bei einzelnen Kontakten/Kontaktreihen oder Kontaktgruppen der Steckverbindungen bzw. Stecker,
Anordnung der Kontakte zueinander: direkt nebeneinander/hintereinander, diagonal,
kann eine praktische Unterstützung bei der Fehlerfindung erfolgen., die Zeit- und Kostenersparnis mit sich bringt und eine einfache Möglichkeit der Lokalisierung von Unterbrechungen bietet.

Kann bei der Kabelbaumauslegung bereits eine entsprechende Anordnung von diagnostizierbaren Signalen/Versorgungen mit den Steckverbindungen berücksichtigt werden, kann die Aussagewahrscheinlichkeit weiter erhöht werden.

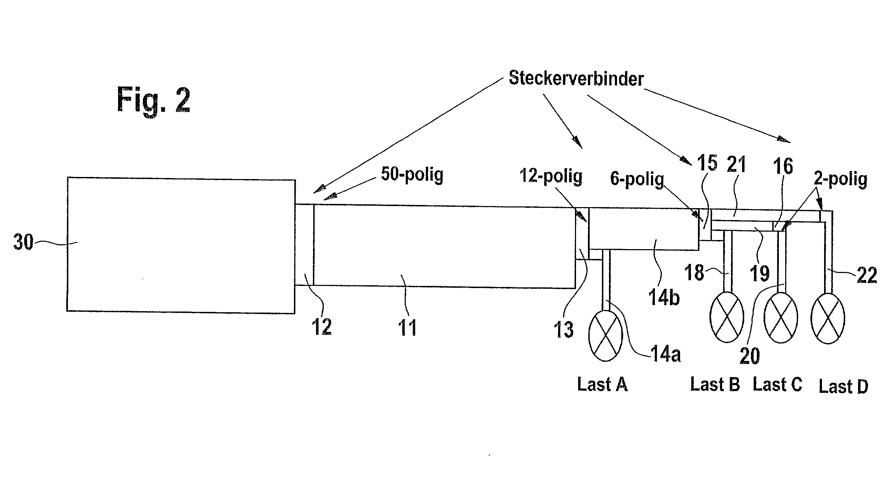

Das Steuergerät 10 kann auch über einen Bus 35 mit einem Diagnosetester 30 verbindbar sein oder es ist wie in Figur 2 dargestellt direkt das Kabel 11 mit dem Diagnosetester 30 verbindbar. Bei diesen Ausgestaltungen können die Verfahren zur Lokalisierung von Unterbrechungen entweder im Steuergerät oder im Diagnosetester oder teilweise im Steuergerät und teilweise im Diagnosetester ablaufen, dies gilt auch für die Anzeigen.

Beim Einsatz eines Diagnosetesters können die vom Diagnosetester abgefragt werden oder es können die Verfahren bzw. die Algorithmen im Diagnosetester ablaufen und angezeigt und /oder ausgedruckt werden. Über einen Anschluß 31 ist eine Informationsausgabe möglich und erlaubt die Fehleranzige in einem beliebigen Display. Die Verfahren laufen beispielsweise in Form einer Fehlersuchanweisung ab.

## Patentansprüche

1. Verfahren zur Lokalisierung von Unterbrechungen bei einem System, mit einem zu überwachenden Strompfad, der Kabel mit unterschiedlicher Aderzahl und unterschiedlich polige Stecker umfaßt und zwischen einer Versorgungseinrichtung, insbesonders einem Steuergerät und Verbrauchern liegt, **dadurch gekennzeichnet, dass** Plausibilitätsuntersuchungen ablaufen, die unter Berücksichtigung der Konstruktionsmerkmale des Kabels oder der Kabel und der Stecker ablaufen und erkannte Unterbrechungen mittels Anzeigemitteln anzeigen.

2. Verfahren zur Lokalisierung von Unterbrechungen nach Anspruch 1, **dadurch gekennzeichnet, dass** eine Klassifizierung von Wahrscheinlichkeiten von auftretenden Fehlern, die zu Unterbrechungen führen, erfolgt und ausgehend von dieser Klassifizierung eine Fehlererkennung bzw. Lokalisierung der Unterbrechung erfolgt.

3. Verfahren zur Lokalisierung von Unterbrechungen nach Anspruch 2, **dadurch gekennzeichnet, dass** die Klassifizierung der Wahrscheinlichkeiten wenigstens eine Kombination von Fehlerinformationen entsprechend einer Funktionskombination einer Steckverbindung oder ein Ausfallverhalten mit Wackelkontaktverhalten umfaßt und bei einzelnen Kontakten oder Kontaktreihen oder Kontaktgruppen eingesetzt wird und die Anordnung der Kontakte zueinander berücksichtigt werden.

4. Verfahren zur Lokalisierung von Unterbrechungen nach Anspruch 3, **dadurch gekennzeichnet, dass** bei der Überprüfung der Anordnung der Kontakte zueinander abgefragt wird, ob es sich um Kontakte direkt nebeneinander oder hintereinander oder diagonal zueinander handelt und diese Information bei der Fehlerfindung mitberücksichtigt wird.

5. Verfahren zur Lokalisierung von Unterbrechungen nach einem der vorhergehenden Ansprüche, **dadurch gekennzeichnet, dass** bei der Ausgestaltung der Kabelanordnung bzw. des Kabelbaumes konstruktive Gegebenheiten berücksichtigt werden, insbesonders eine entsprechende Anordnung von diagnostizierbaren Signalen/Versorgungen in den Steckverbindungen, wodurch die Aussagewahrscheinlichkeit erhöht wird.

6. Verfahren zur Lokalisierung von Unterbrechungen nach einem der vorhergehenden Ansprüche, **dadurch gekennzeichnet, dass** es in Form einer Fehlersuchanweisung abläuft.

7. Vorrichtung Durchführung eines Verfahrens zur Lokalisierung von Unterbrechungen nach einem der vorhergehenden Ansprüche, **dadurch gekennzeichnet, dass** wenigstens ein Prozessor zur Durchführung der Plausibilitätsuntersuchungen sowie Speichermittel vorhanden sind, in denen die zur Durchführung der Plausibilitätsuntersuchungen benötigten Informationen abgespeichert sind.

8. Vorrichtung zur Lokalisierung von Unterbrechungen nach Anspruch 7, **dadurch gekennzeichnet, dass** sie Bestandteil eines Diagnosetesters ist, über den die Fehler abgefragt werden und der selbst Mittel umfaßt, zur Durchführung der Fehlerabfragen und Mittel zur Anzeige oder zum Ausdrucken der Fehler.

9. Vorrichtung zur Lokalisierung von Unterbrechungen nach Anspruch 7 oder 8, **dadurch gekennzeichnet, dass** die Anzeigemittel Bestandteil der Vorrichtung oder des Testers sind und insbesonders als Display ausgetaltet sind.

10. Vorrichtung zur Lokalisierung von Unterbrechungen nach Anspruch 7, 8 oder 9, **dadurch gekennzeichnet, dass** Mittel vorhanden sind, die das Fehlersignal ausgeben, zur Anzeige in einem beliebigen anschließbaren Display.
